Europäisches Patentamt

European Patent Office

Office européen des brevets

(19)

(11) Veröffentlichungsnummer: **0 164 662**

**A1**

(12) # EUROPÄISCHE PATENTANMELDUNG

(21) Anmeldenummer: **85106720.7**

(22) Anmeldetag: **31.05.85**

(51) Int. Cl.⁴: **H 03 K 17/96**

(30) Priorität: **13.06.84 CH 2857/84**

(43) Veröffentlichungstag der Anmeldung:
**18.12.85 Patentblatt 85/51**

(84) Benannte Vertragsstaaten:
**AT BE CH DE FR GB IT LI NL SE**

(71) Anmelder: **FELLER AG.**
**Bergstrasse**
**CH-8810 Horgen(CH)**

(72) Erfinder: **Zetting, Alois**
**Strehlgasse 12**
**CH-8704 Herrliberg(CH)**

(74) Vertreter: **Scheidegger, Zwicky, Werner & Co.**
**Stampfenbachstrasse 48 Postfach**
**CH-8023 Zürich(CH)**

(54) **Elektrische Schalteinrichtung mit mindestens einem piezoelektrischen Organ.**

(57) Ein als mechanisch-elektrischer Wandler dienendes piezoelektrisches Organ (11) ist mit dem Signaleingang (14) einer Schaltungsanordnung (12) verbunden, die einen Ausgang für ein Steuersignal aufweist und ein digitales Bandpassfilter (32) mit einem Durchlassfrequenzbereich von z.B. 0,5 bis 10 Hz, vorzugsweise etwa 2 bis 4 Hz, enthält. Hierdurch sind piezoelektrische Spannungen mit Frequenzen unterhalb und oberhalb des Durchlassbereiches des Bandpassfilters (32) unwirksam und damit ungewollte Steuervorgänge infolge von Temperatureinflüssen, Erschütterungen, Vibrationen und Schallwellen praktisch vollständig vermieden.

Ausser als mechanisch-elektrischer Wandler zum Auslösen eines Steuervorganges kann das piezoelektrische Organ (11) zusätzlich auch als elektrisch-mechanischer Wandler zum Erzeugen von Schallwellen eines akustisch wahrnehmbaren Rückmeldesignals dienen. Die Schaltungsanordnung (12) weist zu diesem Zweck auch einen Tonfrequenzoszillator (42) und Mittel (30, 40, 41, 43) zum vorübergehenden Anschalten des Oszillators (42) an das piezoelektrische Organ (11) jeweils nach dem manuellen Betätigen desselben auf.

FIG.1

0164662

Elektrische Schalteinrichtung mit mindestens einem piezoelektrischen Organ

Gegenstand der vorliegenden Erfindung ist eine elektrische
Schalteinrichtung mit mindestens einem als mechanisch-elektrischer Wandler dienenden piezoelektrischen Organ und einer
elektrischen Schaltungsanordnung, die einen mit dem piezoelektrischen Organ verbundenen Signaleingang und einen Signalausgang für ein elektrisches Steuersignal aufweist.

Bekannte Einrichtungen dieser Art sind häufig mit dem Nachteil behaftet, dass durch Erschütterungen, Schallwellen oder
Wärmeeinflüsse ungewollte Steuervorgänge ausgelöst werden.
Zur Unterdrückung von Störungen infolge von Erschütterungen
und Vibrationen hat man schon ein Tiefpassfilter in der
elektrischen Schaltungsanordnung vorgesehen. Da das verwendete Tiefpassfilter aber lediglich aus einem Längswiderstand
und einem Querkondensator bestand, resultierte nur eine verhältnismässig geringe Filtersteilheit und dementsprechend nur
eine bescheidene Störungsunterdrückung. Thermische Störungseinflüsse, den sogenannten Pyroeffekt, hat man dadurch zu
vermindern versucht, dass für das piezoelektrische Organ
eine besonders dünne Schicht aus Piezomaterial verwendet
wurde. Weiter ist es bekannt, zur Betätigung des piezoelektrischen Organs einen mechanischen Schnapptaster vorzusehen,
mit welchem das piezoelektrische Organ jeweils durch einen
relativ kräftigen Schlag anstossbar ist, um einen hohen
piezoelektrischen Impuls zu erzeugen, der erlaubt, die Ansprechempfindlichkeit der elektrischen Schaltungsanordnung
entsprechend zu vermindern. Hierdurch können die oben erwähnten nachteiligen Störungen ebenfalls vermindert werden, aber
der Schnapptaster verlangt einen erheblichen Schaltweg, der
für manche Anwendungsfälle unzweckmässig ist.

Der vorliegenden Erfindung liegt die Aufgabe zugrunde, eine
Einrichtung der eingangs genannten Art so auszugestalten,

0164632

dass eine ungewollte Auslösung von Steuervorgängen infolge Erschütterungen, Schallwellen oder Wärmeeinflüssen praktisch vollständig ausgeschlossen ist, ohne dass hierfür eine spezielle Ausbildung des piezoelektrischen Organs oder einer Betätigungsvorrichtung zum mechanischen Beaufschlagen des piezoelektrischen Organs erforderlich ist.

Diese Aufgabe ist erfindungsgemäss dadurch gelöst, dass die elektrische Schaltungsanordnung einen Impedanzwandler und ein digitales Bandpassfilter aufweist mit einem Durchlassfrequenzbereich, dessen untere Grenzfrequenz im Bereich von 0,5 Hz bis 2 kHz liegt und dessen obere Grenzfrequenz höchstens 20 mal höher als die untere Grenzfrequenz ist.

Ein digitales Bandpassfilter zeigt bekanntlich eine im Vergleich mit anderen elektrischen Filtern hohe Flankensteilheit an beiden Enden des Durchlassbereiches. Daher sind bei der erfindungsgemässen Einrichtung alle piezoelektrischen Impulse oder Schwingungen mit einer unterhalb oder oberhalb des Durchlassbereiches des digitalen Bandpassfilters liegenden Frequenz völlig unwirksam. Weder langsam auftretende thermische Einflüsse noch Erschütterungen durch Vibrationen und Schallwellen mit Frequenzen ausserhalb des Durchlassbereiches des digitalen Bandpassfilters können ungewollte Steuervorgänge auslösen.

Piezoelektrische Organe lassen sich praktisch weglos betätigen, da hierfür Deformationen in der Grössenordnung von 1 bis 10 µm ausreichen. Für die Bedienungsperson kann daher, wenn das Resultat der vorgenommenen Betätigung nicht ohne weiteres am Verhalten des zu steuernden elektrischen Gerätes od.dgl. erkennbar ist, eine gewisse Unsicherheit darüber entstehen, ob die Schalteinrichtung auch tatsächlich angesprochen hat. Zur Beseitigung dieser Unsicherheit sind bereits Massnahmen zum Herbeiführen einer Rückmeldung an die Bedienungsperson bekannt geworden, wobei diese Rückmeldung optisch, akustisch oder mittels eines schwachen elektrischen Stromstosses erfolgen kann.

Es ist nun eine weitere Aufgabe der vorliegenden Erfindung, eine zweckmässige akustische Rückmeldung an die Bedienungsperson zu ermöglichen.

Diese zusätzliche Aufgabe ist erfindungsgemäss dadurch gelöst, dass das piezoelektrische Organ ausser als mechanisch-elektrischer Wandler zum Auslösen eines Steuervorganges auch als elektrisch-mechanischer Wandler zum Erzeugen von Schallwellen eines akustisch wahrnehmbaren Signals vorgesehen ist und dass die elektrische Schaltung mindestens einen Tonfrequenzoszillator sowie Mittel zum zeitweisen Anschalten desselben an das piezoelektrische Organ aufweist. Durch diese Massnahme wird ein zusätzlicher akustischer oder optischer Signalgeber entbehrlich.

Aus der CH-Patentschrift 506 835 oder der entsprechenden US-Patentschrift 3 676 696 ist eine Zeitmesseinrichtung für Wettschwimmen bekannt, welche eine an einer Wand eines Schwimmbeckens zu befestigende Zielanschlagplatte aufweist, die mit zwei oder mehr piezoelektrischen Organen in mechanischer Wirkungsverbindung steht, wobei die piezoelektrischen Organe an eine elektrische Schaltungsanordnung zum Erzeugen eines Steuersignals für eine Uhr angeschlossen sind. Bei dieser bekannten Zeitmesseinrichtung sind die piezoelektrischen Organe je in einem an der Zielwand des Schwimmbeckens oberhalb des Wasserspiegels stationär angeordneten Halter für die Zielanschlagplatte untergebracht, und letztere ist als biegesteife Metallplatte ausgebildet, die bei Berührung durch einen Schwimmer in Schwingungen mit verhältnismässig hoher Frequenz versetzbar ist, um dadurch mindestens eines der piezoelektrischen Organe zu betätigen. Damit unbeabsichtigte Steuersignale infolge von Wellenschlag möglichst vermieden werden, ist die Anschlagplatte durch eine Vielzahl

0164662

von Bohrungen mechanisch bedämpft und die elektrische Schaltungsanordnung derart ausgebildet, dass piezoelektrische
Signale mit unterhalb eines Schwellenwertes liegenden Amplituden unterdrückt und solche mit über einer bestimmten Frequenz liegenden Frequenzen bevorzugt werden.

In der Praxis hat sich gezeigt, dass bei dieser bekannten
Zeitmesseinrichtung der Schwellenwert für die Amplitude der
piezoelektrischen Signale jeweils möglichst hoch eingestellt
werden muss, damit das Auftreten von unbeabsichtigten Steuersignalen wirksam vermieden ist. Eine Folge hiervor ist, dass
der Schwellenwert für verschiedene Wettbewerbsarten und
Kategorien von Schwimmern, z.B. Spitzensportler, Junioren,
Kinder, anders eingestellt werden muss, um jeweils einen optimalen Kompromiss zwischen der Unterdrückung von Fehlsignalen
und der zum Betätigen der Einrichtung nötigen Anschlagstärke
zu erzielen.

Es besteht daher das Bedürfnis, eine Zeitmesseinrichtung für
Wettschwimmen zu schaffen, bei welcher die lästige und komplizierte Empfindlichkeitseinstellung für die verschiedenen
Wettbewerbsarten und Schwimmer entfällt. Dieses Ziel ist gemäss der vorliegenden Erfindung dadurch erreicht, dass die
elektrische Schaltungsanordnung einen Impedanzwandler und
ein digitales Bandpassfilter aufweist mit einem Durchlassbereich, dessen untere Grenzfrequenz 0,5 bis 2 kHz und dessen
obere Grenzfrequenz 5 bis 20 kHz betragen, wobei vorzugsweise der Durchlassbereich sich von 1 bis 10 kHz erstreckt.

Es wurde weiter gefunden, dass bei dieser erfindungsgemässen
Ausbildung der elektrischen Schaltungsanordnung die Zielanschlagplatte anstatt aus Metall mit Vorteil aus einem Hart-
Kunststoff oder Hart-Kunststoffschaum gebildet sein kann und
die piezoelektrischen Organe je in einer Vertiefung an einer
Flachseite der Anschlagplatte befestigt und gegen den Zutritt
von Wasser abgedichtet sein können. Dies erlaubt eine einfachere und schneller durchzuführende Befestigung der Anschlagplatte an der Zielwand eines Schwimmbeckens und bringt
den Vorteil eines niedrigeren Gewichts der Anschlagplatte.

Einzelheiten, Weiterbildungen und Vorteile der Erfindung ergeben sich aus den Patentansprüchen, aus der nun folgenden
Beschreibung von Ausführungsbeispielen und aus den zugehörigen Zeichnungen, in welchen die Erfindung rein beispielsweise veranschaulicht ist.

Fig. 1 ist ein elektrisches Blockschaltbild eines ersten
       Ausführungsbeispiel der erfindungsgemässen Schalteinrichtung, nämlich einer Schalteinrichtung zum
       Steuern der Speisung eines elektrischen Energieverbrauchers;

Fig. 2 zeigt schematisch die elektrische Schaltungsanordnung
       eines Ausführungsbeispiels des digitalen Bandpassfilters der Schalteinrichtung gemäss Fig. 1;

Fig. 3 veranschaulicht einen Querschnitt durch ein hermetisch
       geschlossenes Gehäuse, in welchem das piezoelektrische Organ und die zugehörigen elektrischen Schaltungsanordnungen der Schalteinrichtung gemäss Fig. 1 untergebracht sind;

Fig. 4 zeigt eine Draufsicht auf die Betätigungsseite des
       Gehäuses gemäss Fig. 3;

Fig. 5 ist eine perspektivische Darstellung einer Partie
       eines Schwimmbeckens mit Einrichtungen für die Zeitmessung bei Wettschwimmen, welche Einrichtungen er-
       findungsgemäss ausgebildete Schalteinrichtungen auf-
       weisen;

Fig. 6 zeigt eine perspektivische Ansicht einer mit zahlrei-
       chen piezoelektrischen Organen versehenen Zielan-

schlagplatte für eine Zeitmesseinrichtung für Wettschwimmen;

Fig. 7 und Fig. 8 sind analoge Darstellungen von Ausführungsvarianten der Zielanschlagplatte gemäss Fig. 6;

Fig. 9 zeigt eine Partie der Zielanschlagplatte mit einem
einzelnen piezoelektrischen Organ im Schnitt entlang
der Linie 9-9 in Fig. 6;

Fig. 10 ist eine Unteransicht einer mit mehreren piezoelektrischen Organen versehenen Startplatte für einen Wettschwimmer;

Fig. 11 zeigt ein elektrisches Schaltschema einer erfindungsgemässen Schalteinrichtung für eine elektronische
Zeitmesseinrichtung für Wettschwimmen; und

Fig. 12 veranschaulicht den zeitlichen Verlauf mehrerer
elektrischer Signale an verschiedenen Stellen eines
digitalen Bandpassfilters in der Schaltungsanordnung
nach Fig. 10.

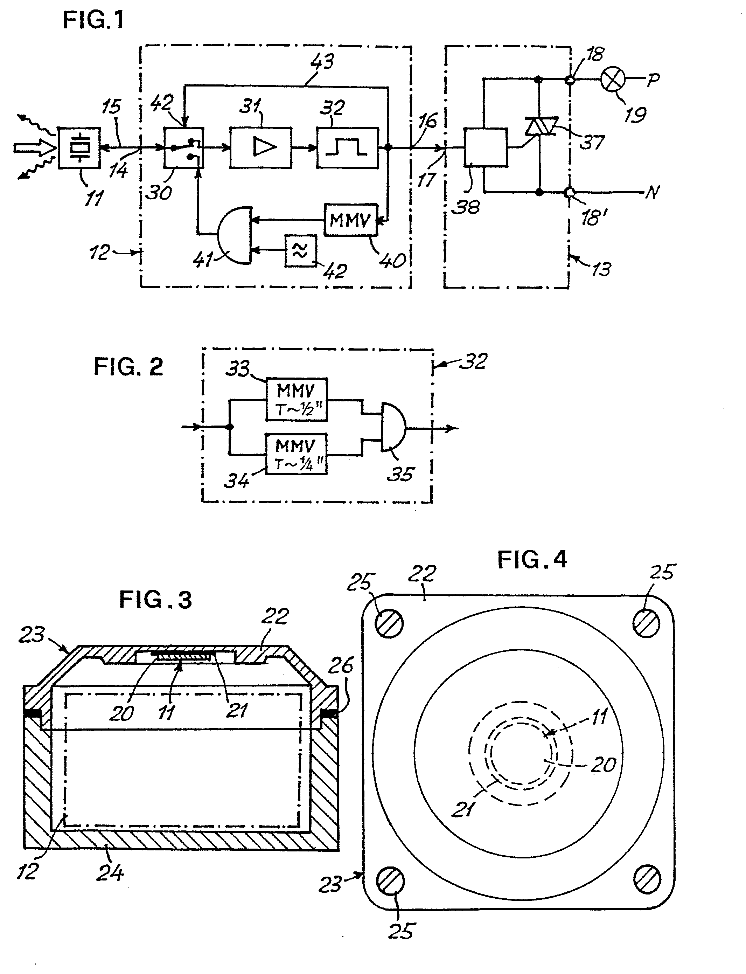

Die in Fig. 1 schematisch dargestellte Schalteinrichtung
weist ein piezoelektrisches Organ 11 und elektrische Schaltungsanordnungen 12 und 13 auf. Ein Signaleingang 14 der
ersten Schaltungsanordnung 12 ist über eine elektrische Zweidrahtleitung 15 mit dem piezoelektrischen Organ 11 verbunden,
während ein Signalausgang 16 dieser Schaltungsanordung 12
mit einem Steuersignaleingang 17 der zweiten Schaltungsanordnung 13 in Verbindung steht. Letzterer weist Anschlussklemmen
18 und 18' auf zum Anschliessen eines elektrischen Energieverbrauchers 19, z.B. einer Glühlampe, bzw. eines Leiters N
eines elektrischen Wechselstromverteilnetzes. Ein anderer
Leiter P des Wechselstromverteilnetzes steht mit dem Verbraucher 19 in Verbindung.

Das piezoelektrische Organ 11 besteht zweckmässig aus einem
scheibenförmigen Piezokeramikkörper 20 (Fig. 3 und 4), der
auf seinen beiden Flachseiten je mit einem aufgedampften
Elektrodenbelag (in der Zeichnung nicht sichtbar) versehen
ist. In bekannter Weise kann der Piezokeramikkörper z.B. aus
Blei-Zirkonat-Titan-Pulver gesintert sein. Der Piezokeramikkörper kann mit Vorteil auch aus einem ternären System von
Bleititanat, Bleizirkonat und Blei-Nickel-Niobat bestehen.
Der Durchmesser des scheibenförmigen Piezokeramikkörpers 20
beträgt zweckmässig 10 bis 20 mm, während die Dicke der
Scheibe 20 z.B. 0,5 bis 3 mm messen kann.

Gemäss Fig. 3 ist die obere Elektrode des piezoelektrischen
Organs 11 mit einer im Durchmesser etwas grösseren Metallscheibe 21 verbunden, und zwar mit Hilfe eines elektrisch
leitenden Klebstoffes. Die Metallscheibe 21 ihrerseits ist
an der Innenseite eines Deckels 22 eines Gehäuses 23 flach
anliegend festgeklebt. Die beiden Leiter der bereits erwähnten Zweidrahtleitung 13 sind auf nicht dargestellte Weise mit
der unteren Elektrode des piezoelektrischen Organs 11 bzw.
mit der Metallscheibe 21 elektrisch verbunden.

Das Gehäuse 23, das je nach dem Verwendungszweck aus polymerem Kunststoff oder aus Metall bestehen kann, weist einen Unterteil 24 auf, an welchem der Deckel 22 mittels Schrauben 25
(Fig. 4) lösbar befestigt ist. Zwischen dem Deckel 22 und dem
Unterteil 24 des Gehäuses 23 ist ein elastisch nachgiebiger
Dichtungsring 26 eingeschaltet. Das ganze Gehäuse 23 ist somit staubdicht und wasserdicht geschlossen. Im Innern des Gehäuses 23 sind die elektrischen Schaltungsanordnungen 12 und
13 untergebracht, die nun im einzelnen näher erläutert werden.

Die erste Schaltungsanordnung 12 weist gemäss Fig. 1 eine
elektronische Umschaltvorrichtung 30 auf, die z.B. aus einem
integrierten Schaltkreis des Typs CMOS 4066 gebildet sein
kann. Im Ruhezustand der Umschaltvorrichtung 30 verbindet diese die Leitung 13 mit einem Impedanzwandler 31, der die
etwa 10 bis 15 M.Ω betragende Impedanz des piezoelektrischen
Organs 11 auf einen beträchtlich niedrigeren Wert umwandelt.
Gegebenenfalls kann der Impedanzwandler 31 auch eine Verstärkung der piezoelektrischen Spannung bewirken.

Dem Impedanzwandler 31 ist ein digitales Bandpassfilter 32
nachgeschaltet, dessen Durchlassfrequenzbereich 0,5 bis 10
Hz, vorzugsweise jedoch nur etwa 2 bis 4 Hz, beträgt. Das
Bandpassfilter 32 kann z.B. gemäss dem Schaltschema nach
Fig. 2 ausgebildet sein. Bei dieser Ausführungsform weist
das Bandpassfilter 32 zwei monostabile Multivibratoren 33
und 34 auf, welche retriggerbar sind, d.h. durch jedes Eingangssignal neu getriggert werden, auch wenn die Eigenschaltzeit noch nicht abgelaufen ist. Die Eingänge der zwei monostabilen Multivibratoren 33 und 34 sind zusammengeschaltet,
während ihre Ausgänge je mit einem Eingang eines elektronischen UND-Gatters 35 verbunden sind. Die Eigenschaltzeit des
monostabilen Multivibrators 33 ist gleich der Periodenlänge
T eines Eingangssignals mit der unteren Grenzfrequenz des
Durchlassbereiches des Bandfilters 32. Somit beträgt die
Eigenschaltzeit des monostabilen Multivibrators 33 vorzugsweise etwa 1/2 Sekunden. Der andere monostabile Multivibrator
34 hat eine Eigenschaltzeit von etwa 1/4 Sekunde, d.h. gleich
der Periodenlänge T eines Eingangssignals mit der oberen
Grenzfrequenz des Durchlassbereiches des Bandfilters 32. Der
Ausgang des digitalen Bandfilters 32 ist mit dem Signalausgang
16 der Schaltungsanordnung 12 verbunden.

Die zweite Schaltungsanordnung 13 weist einen zwischen den
Anschlussklemmen 18 und 18' liegenden Triac 37 und eine zugehörige Steuerstufe 38 auf. Diese Steuerstufe 38 kann z.B. mit
Hilfe eines integrierten Schaltkreises des Typs S 576 C oder
des Typs S 576 B aufgebaut sein. Im ersten Fall lässt sich der
elektrische Energieverbraucher 19 mittels der beschriebenen
Einrichtung lediglich ein- und ausschalten. Im zweiten Fall hingegen ist eine kontinuierlich veränderbare Phasenanschnittsteuerung möglich, um die Energiezufuhr zum Verbraucher 19
stufenlos zu regulieren.

Gemäss Fig. 1 ist der Ausgang 16 der Schaltungsanordnung 12
auch mit einem weiteren monostabilen Multivibrator 40 verbunden, der eine Eigenschaltzeit im Bereich von 0,2 bis 1 Sekunde aufweist. Der Ausgang dieses monostabilen Multivibrators
40 ist an einen Eingang eines weiteren elektronischen UND-
Gatters 41 angeschlossen, dessen anderer Eingang mit dem Ausgang eines Tonfrequenzoszillators 42 verbunden ist. Der Ausgang des UND-Gatters 41 steht mit der bereits beschriebenen
Umschaltvorrichtung 30 in Verbindung und lässt sich durch
letztere mit dem piezoelektrischen Organ 11 verbinden. Ein
Steuereingang 42 der elektronischen Umschaltvorrichtung 30
ist mittels eines Leiters 43 ebenfalls mit dem Ausgang 16 der
Schaltungsanordung 12 verbunden.

Die Gebrauchs- und Wirkungsweise der beschriebenen Einrichtung
ist kurz z.B. wie folgt:

Es ist zunächst angenommen, dass die Steuerstufe 38 lediglich
zum Ein- und Ausschalten der Energiezufuhr zum elektrischen
Verbraucher 19 ausgebildet ist. Durch einen Fingerdruck auf
die Aussenseite der Mittelpartie des Deckels 22 des Gehäuses
23 lässt sich der Deckel 22 um 1 bis 10 µm elastisch deformieren, wodurch der Piezokeramikkörper 20 des piezoelektrischen Organs 11 eine geringfügige Biegung erfährt. Diese Biegung reicht aus zur Erzeugung einer piezoelektrischen Spannung, die über die Umschaltvorrichtung 30 und den Impedanzwandler 31 dem Bandpassfilter 32 zugeleitet wird. Wenn die
piezoelektrisch erzeugte Spannung eine Frequenz innerhalb des
Durchlassbereiches des Bandpassfilters 32 hat, erscheint am
Ausgang 16 der Schaltungsanordnung 12 ein Steuersignal, das
in der Steuerstufe 38 bis zum Eintreffen eines später ankommenden neuen Signals gespeichert wird. Mittels der Steuerstufe 38 werden Zündimpulse zum Steuern des Triac 37 erzeugt,
der folglich durchschaltet, so dass elektrische Energie dem
Verbraucher 19 zugeführt wird. Vom Ausgang des Bandpassfilters 32 werden elektrische Steuersignale auch an den monostabilen Multivibrator 40 und an den Steuereingang 42 der
Umschaltvorrichtung 30 geliefert. Demzufolge wird mittels
der Umschaltvorrichtung 30 das piezoelektrische Organ 11
vom Impedanzwandler 31 abgetrennt und an den Ausgang des UND-
Gatters 41 angeschlossen. Ferner bewirkt der monostabile
Multivibrator 40, dass während seiner z.B. 0,2 bis 1 Sekunde
dauernden Eigenschaltzeit der Ausgang des Oszillators 42 über
das UND-Gatter 41 mit der Umschaltvorrichtung 30 verbunden
wird. Durch das tonfrequente Ausgangssignal des Oszillators
42 wird nun das piezoelektrische Organ 11 zu Schwingungen
angeregt, die akustisch wahrnehmbare Schallwellen hervorrufen.
Es entsteht also ein Piepston, welcher der Bedienungsperson
als Rückmeldung über das Zustandekommen des gewünschten
Steuervorganges dient. Nachher kehrt die Umschaltvorrichtung 30 automatisch in ihren Ausgangszustand zurück.

Bei einem erneuten Fingerdruck auf den Deckel 22 des Gehäuses
23 wiederholen sich die beschriebenen Vorgänge, wobei jedoch
die Steuerstufe 38 nun einen Ruhezustand annimmt und keine
weiteren Zündimpulse mehr an den Triac 37 liefert, weshalb
die Energiezufuhr zum Verbraucher 19 unterbrochen wird. Auch
in diesem Fall erfolgt wieder eine akustische Rückmeldung an
die Bedienungsperson.

Die für die Auslösung eines Steuervorganges benötigte Kraft
auf den Deckel 22 des Gehäuses 23 ist überraschend gering;
sie liegt - je nach Form, Grösse und Material des Deckels -
im Bereich von 0,1 bis 10 N.

Wenn anstelle eines Fingerdruckes ein kräftiger Schlag auf den
Deckel 22 des Gehäuses 23 ausgeübt wird, entstehen im Deckel
22 und im Piezokeramikkörper 20 Vibrationen mit Frequenzen,

0164662

die höher als die obere Grenzfrequenz des Durchlassbereiches des Bandpassfilters 32 sind. In diesem Fall gelangt kein Steuersignal an den Ausgang 16 der Schaltungsanordnung 12, und es erfolgt kein Steuervorgang. Das Gleiche gilt für irgendwelche Vibrationen oder Erschütterungen mit oberhalb des Durchlassbereiches des Bandpassfilters liegenden Frequenzen. Ebenso sind langsame Formänderungen des piezoelektrischen Organs 11, z.B. infolge von Temperatureinflüssen, nicht imstande, irgendwelche Steuervorgänge auszulösen.

Für den Fall, dass die Steuerstufe 38 mit einem integrierten Schaltkreis des Typs S 576 B ausgerüstet ist, kann man mit der beschriebenen Einrichtung die Energiezufuhr zum elektrischen Verbraucher 19 durch Phasenanschnittsteuerung stufenlos steuern. Die Bedienung erfolgt dann z.B. wie folgt: Beim ersten Drücken auf den Deckel 22 wird der Verbraucher eingeschaltet, wonach die Energiezufuhr automatisch periodisch langsam aufwärts und abwärts gesteuert wird. Durch ein zweites Drücken lässt sich die automatische Auf- und Abwärtssteuerung stoppen. Durch zweimaliges Drücken kurz nacheinander wird die Energiezufuhr zum Verbraucher ganz unterbrochen.

Es sind im Handel auch andere integrierte Schaltkreise zur stufenlosen Steuerung der Energiezufuhr erhältlich, wobei von der vorstehenden Beschreibung zum Teil abweichende Betätigungen erforderlich sind.

In Abänderung des Aufführungsbeispiels gemäss Fig. 1 kann anstelle des Triac 37 ein elektromagnetisches Relais zum Ein- und Ausschalten des elektrischen Energieverbrauchers 19 vorhanden sein.

Bei einer anderen, ebenfalls nicht dargestellten Ausführungsvariante kann anstelle des Oszillators 42 und des UND-Gatters 41 ein sogenannter Start-Stop-Oszillator vorgesehen sein, der jeweils durch den monostabilen Multivibrator 40 während der Eigenschaltzeit des letzteren in Betrieb gesetzt wird.

In einer weiteren, nicht dargestellten Ausführungsform können
zwei oder mehr tonfrequente Oszillatoren vorhanden sein, die
jeweils gleichzeitig oder zeitlich nacheinander für die akustische Rückmeldung aktiviert werden. Auf diese Weise ergibt
sich ein besser wahrnehmbares akustisches Rückmeldesignal.

Bei einer vereinfachten Schaltungsanordnung können die elektronische Umschaltvorrichtung 30, der monostabile Multivibrator 40, das UND-Gatter 41, der Oszillator 42 und der Leiter
43 weggelassen sein, wenn auf eine akustische Rückmeldung
verzichtet wird.

Alle erwähnten Ausführungsformen der erfindungsgemässen Schalteinrichtung bieten eine Reihe von Vorteilen, wie insbesondere
die folgenden:

Ungewollte Steuervorgänge durch Erschütterungen, Vibrationen,
Schallwellen und Temperatureinflüsse sind praktisch völlig
ausgeschlossen. Das Auslösen oder Einleiten eines Steuervorganges erfolgt praktisch weglos. Im Gegensatz zu sogenannten
Sensortasten, die auf dem Prinzip der Stromableitung über die
menschliche Haut beruhen, kann die Betätigung auch mit isolierenden Teilen, z.B. mit Handschuhen oder mit einem bekleideten
Ellbogen, geschehen, ebenso durch Personen, die auf einer isolierenden Unterlage stehen oder sitzen. Da keine beweglichen
Teile vorhanden sind, ist die Lebens- und Gebrauchsdauer der
Einrichtung praktisch unbeschränkt. Da das piezoelektrische
Organ 11 innerhalb eines geschlossenen Gehäuses 23 angeordnet
sein kann, lässt es sich gegen Feuchte, Staub, Chemikalien
usw. wirksam schützen und können die Aussenflächen des Gehäuses mühelos sauber gehalten werden.

Schalteinrichtungen der beschriebenen Art sind daher besonders
geeignet zur Verwendung im Freien, in Räumen mit nasser und/
oder staubiger Atmosphäre, in Bergstollen, in explosionsgefährdeten Räumen, in Lebensmittelbetrieben, in Spitälern
usw.

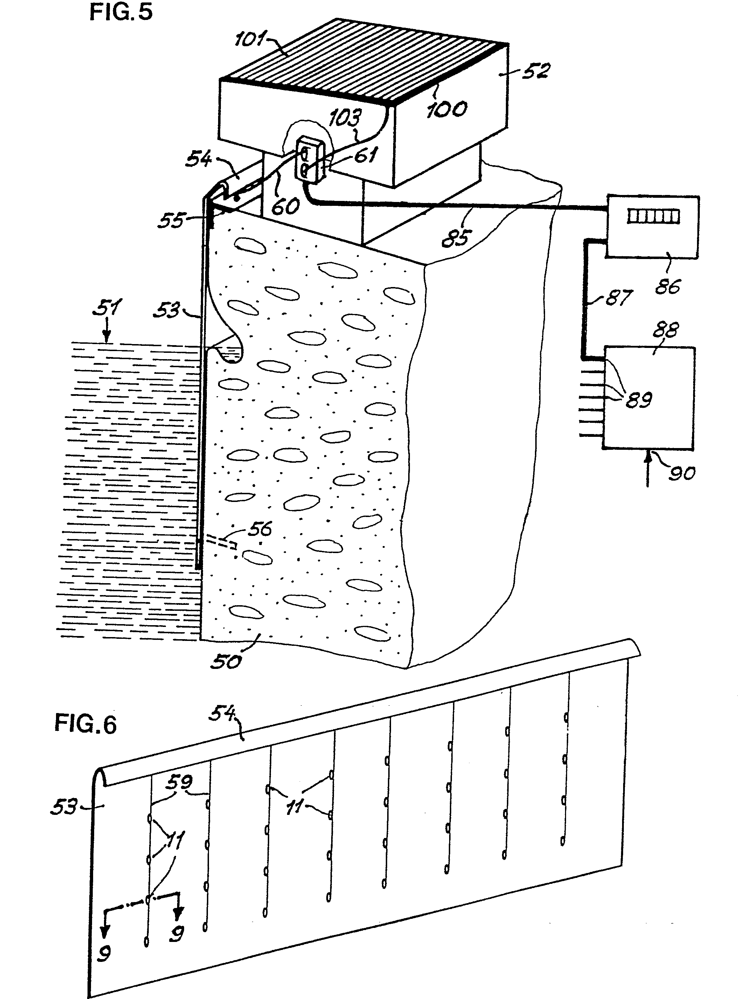

In den Fig. 5 bis 12 sind weitere Ausführungsbeispiele der
erfindungsgemässen Schalteinrichtung im Zusammenhang mit einer elektronischen Zeitmesseinrichtung für Wettschwimmen veranschaulicht. In Fig. 5 ist die Start- und Zielwand 50 eines
Schwimmbeckens 51 ersichtlich. Auf der Wand 50 befindet sich
ein üblicher Startbock 52 für einen Wettschwimmer. Innerhalb
des Schwimmbeckens 51 ist an der Wand 50 eine vertikal angeordnete Zielanschlagplatte 53 befestigt, deren Gestalt und
Ausbildung in Fig. 6 deutlicher sichtbar ist. Die horizontale
Abmessung der Platte 53 ist wenige cm kleiner als die Breite
der dem Schwimmer zugedachten Bahn und beträgt vorzugsweise
2,40 m. In der Vertikalen misst die Platte 53 etwa 90 cm, wobei etwas mehr als die halbe Höhe der Platte in das Wasser
des Schwimmbeckens eingetaucht ist. Zur Versteifung weist
die Platte 53 oben einen umgebogenen Rand 54 auf. An der oberen Kante der Wand 50 ist eine horizontal verlaufende Winkelprofilschiene 55 befestigt, an welcher die Platte 53 auf nicht
näher gezeigte Weise aufgehängt ist. In der Nähe ihres unteren
Endes ist die Platte 53 ferner mit einigen weiteren Befestigungsorganen 56 mit der Wand 50 verbunden. Zwischen der Platte 53 und der Wand 50 befindet sich ein verhältnismässig
schmaler freier Zwischenraum.

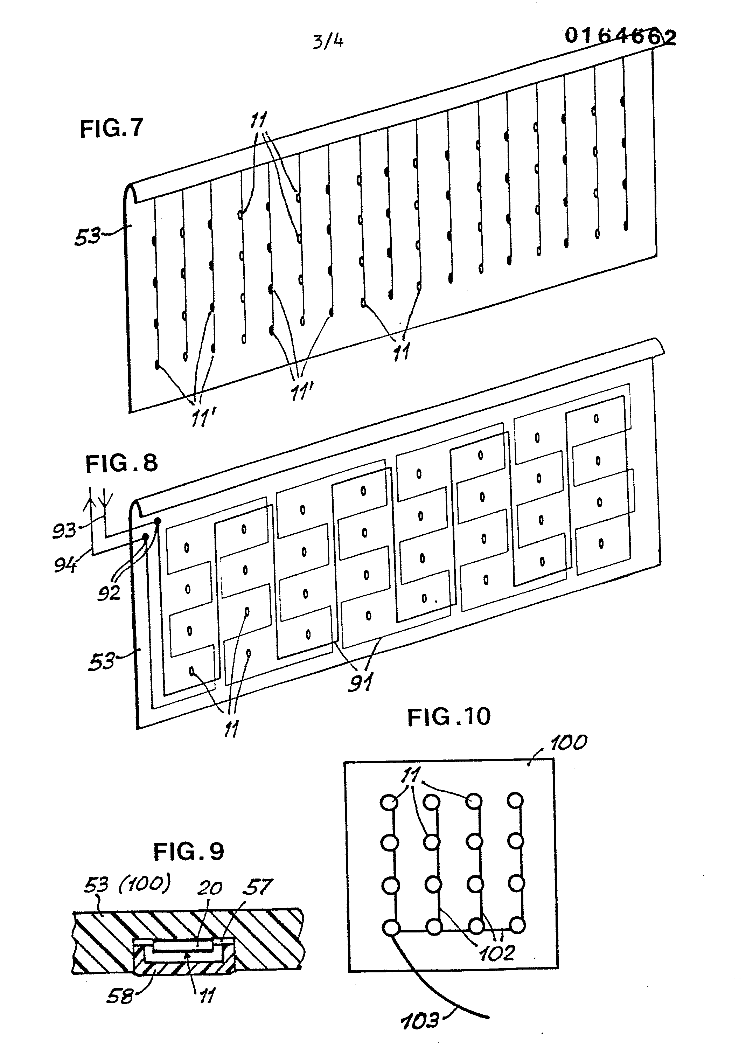

Die Zielanschlagplatte 53 besteht zweckmässig aus einem polymeren Hartkunststoff, vorzugsweise aus Hart-Polyvinylchlorid
oder Polyvinylchlorid-Hartschaum, wobei in jedem der genannten Fälle die Dicke der Platte etwa 6 mm beträgt. An der der
Wand 50 zugewandten Flachseite der Platte 53 ist eine Mehrzahl von piezoelektrischen Organen 11 in Abständen voneinander angeordnet, z.B. 32 Stück in acht vertikalen Reihen mit
je vier piezoelektrischen Organen, wie in Fig. 6 veranschaulicht ist. Gemäss Fig. 9 ist jedes der piezoelektrischen Organe 11 in einer Vertiefung 57 der Zielanschlagplatte 53 befestigt und durch einen Deckel 58 od.dgl. gegen Berührung mit
Wasser geschützt. Jedes piezoelektrische Organ 11 weist - wie
mit Bezug auf das erste Ausführungsbeispiel und insbesondere

Fig. 3 beschrieben wurde - einen Piezokeramikkörper 20 in
Form einer flachen Scheibe auf, die an ihren gegenüberliegenden Flachseiten je mit einem (nicht dargestellten) Elektrodenbelag versehen ist. Der Piezokeramikkörper kann zweckmässig einen Durchmesser im Bereich von 10 bis 20 mm und
eine Dicke im Bereich von 0,5 bis 3 mm haben. Mittels eines
Klebstoffes ist jedes piezoelektrische Organ 11 mit einer
seiner Flachseiten am inneren Ende der zugeordneten Vertiefung 57 befestigt. Sämtliche piezoelektrischen Organe 11 an
der Zielanschlagplatte 53 sind elektrisch parallel geschaltet,
wobei die elektrischen Anschluss- und Verbindungsleiter in
Nuten 59 der Platte 53 eingebettet und gegen das Eindringen
von Wasser abgedichtet sind. Vorzugsweise befinden sich alle
Vertiefungen 57 und Nuten 59 an der gleichen, der Wand 50 zugewandten Flachseite der Zielanschlagplatte 53.

Gegenüber einer aus Metall bestehenden Zielanschlagplatte,
wie sie bisher üblich ist, hat die beschriebene Kunststoff-
Platte 53 die Vorteile geringeren Gewichts und der Möglichkeit,
in ihrer Masse eingefärbt zu werden, so dass Abnützungen der
Plattenoberfläche durch den Gebrauch keine Farbverluste zur
Folge haben.

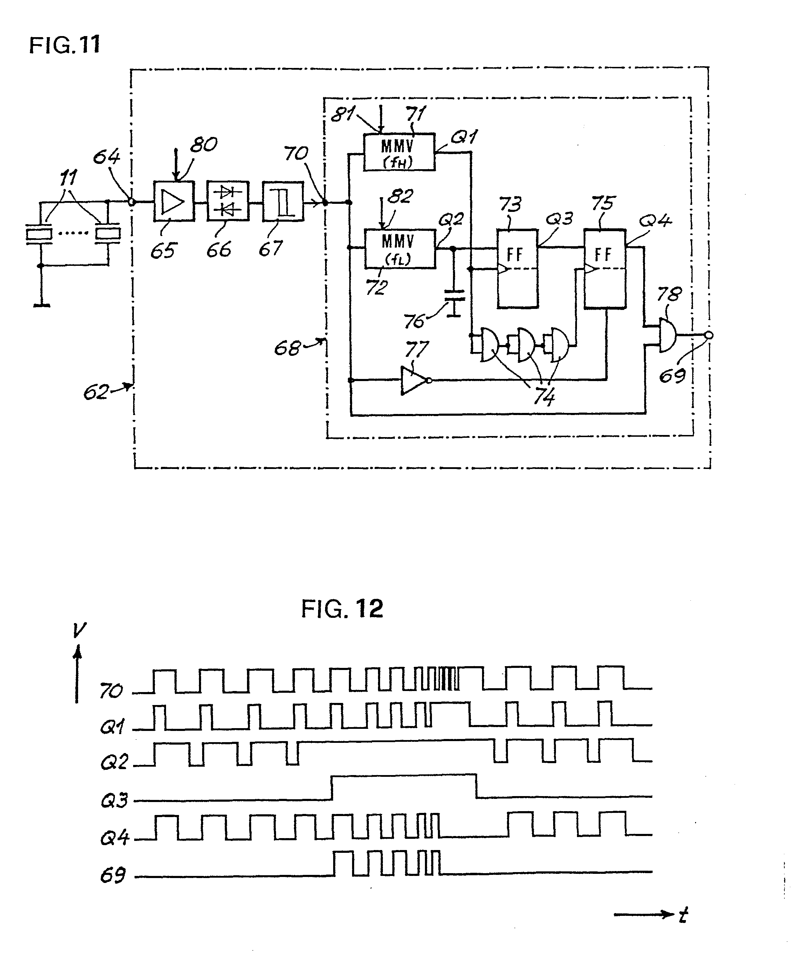

Gemäss Fig. 5 führt ein den piezoelektrischen Organen 11 an der
Platte 53 gemeinsames Anschlusskabel 60 zu einem Gerätegehäuse
61, in welchem eine elektrische Schaltungsanordnung 62 (Fig.
11) zur Auswertung von piezoelektrischen Signalen der Organe
11 untergebracht ist. Nach Fig. 11 weist die Schaltungsanordnung 62 einen Signaleingang 64, einen als Impedanzwandler
dienenden Verstärker 65 für die dem Eingang 64 zugeleiteten
piezoelektrischen Signale, einen Zweiweggleichrichter 66 zum
Gleichrichten der Ausgangssignale des Verstärkers 65, einen
Schmitt-Trigger 67, ein digitales Bandpassfilter 68 und einen
Ausgang 69 für Steuersignale auf. Das digitale Bandpassfilter
68 hat einen Durchlassfrequenzbereich, dessen untere Grenzfrequenz $f_L$ zwischen 500 Hz und 2 kHz liegt und dessen obere Grenzfrequenz $f_H$ 5 bis 20 kHz beträgt. Vorzugsweise ist die untere Grenzfrequenz etwa 1 kHz und die obere Grenzfrequenz etwa 10 kHz. Dies wird z.B. durch die folgende Ausbildung des Bandpassfilters 68 erzielt:

An den Signaleingang 70 des Bandpassfilters 68 sind die Triggereingänge von zwei monostabilen Multivibratoren oder Mono-Flops 71 und 72 angeschlossen. Die Eigenschaltzeit des monostabilen Multivibrators 71 ist gleich der Periodenlänge eines Eingangssignals mit der oberen Grenzfrequenz $f_H$ des Durchlassbereichs des Bandpassfilters, wogegen die Eigenschaltzeit des andern monostabilen Multivibrators 72 gleich der Periodenlänge eines Eingangssignals mit der unteren Grenzfrequenz $f_L$ des Durchlassbereichs ist. Der Ausgang Q1 des monostabilen Multivibrators 71 ist mit dem Triggereingang eines ersten bistabilen Multivibrators oder Flip-Flops 73 und zugleich über eine Verzögerungs-Gatterkette 74 auch mit dem Triggereingang eines zweiten Flip-Flops 75 verbunden. Der Ausgang Q2 des andern monostabilen Multivibrators 72 ist an den Setzeingang des ersten Flip-Flops 73 und an einen Verzögerungs-Kondensator 76 angeschlossen. Der Ausgang Q3 des ersten Flip-Flops 73 steht mit dem Setzeingang des zweiten Flip-Flops 75 in Verbindung, während der Rücksetzeingang des zweiten Flip-Flops 75 über einen Signalinverter 77 an den Signaleingang 70 des Bandpassfilters angeschlossen ist. Die beiden Eingänge eines UND-Gatters 78 sind mit dem Signaleingang 70 bzw. dem Signalausgang Q4 des zweiten Flip-Flops 75 verbunden, während der Ausgang des UND-Gatters 78 an den Steuersignalausgang 69 angeschlossen ist.

Der Verstärker 65 weist einen Steuereingang 80 auf zum Zuführen eines externen Steuersignals zum Regulieren des Verstärkungsgrades. In ähnlicher Weise sind die beiden monostabilen Multivibratoren 71 und 72 je mit einem Steuereingang 81 bzw. 82 versehen zum Zuführen eines externen Steuersignals zum Verändern der Eigenschaltzeit und somit der betreffenden Grenzfrequenz $f_H$ bzw. $f_L$ des Durchlassbereichs des Bandpassfilters 68. Die erwähnten Steuersignale können zweckmässig Gleichspannungen oder digitale Impulsfolgen sein.

In Fig. 12 ist der zeitliche Verlauf der digitalen Signale
am Eingang 70 des Bandpassfilters 68, an den Ausgängen Q1,
Q2, Q3 und Q4 der monostabilen und bistabilen Multivibratoren 71, 72, 73 bzw. 75 sowie am Steuersignalausgang 69 der
Schaltungsanordnung 62 beispielsweise dargestellt. Man erkennt, dass am Ausgang 69 der Schaltungsanordung 62 ein
Steuersignal nur dann erscheint, wenn das piezoelektrisch erzeugte Eingangssignal am Eingang 70 des Bandpassfilters 68
eine Periode aufweist, die nicht kürzer als die Eigenschaltzeit des monostabilen Multivibrators 71 und nicht länger als
die Eigenschaltzeit des andern monostabilen Multivibrators 72
ist. Dies bedeutet mit anderen Worten, dass ein Steuerausgangssignal am Ausgang 69 jeweils nur dann hervorgerufen
wird, wenn das piezoelektrische Eingangssignal eine Frequenz
innerhalb des Durchlassbereichs des digitalen Bandpassfilters 68 aufweist. Hierdurch ist erreicht, dass weder durch
Wasserwellen im Schwimmbecken 51 noch durch harte Schläge auf
die Zielanschlagplatte 53 oder die Wand 50 des Schwimmbeckens
ein Steuersignal hervorgerufen wird, wohl aber durch das übliche Anschlagen einer Hand eines Schwimmers an der Zielanschlagplatte 53.

In Fig. 5 ist weiter schematisch veranschaulicht, dass von
dem Gerät 61 ein Kabel 85 zu einer elektronischen Uhr 86
führt, die ihrerseits mittels eines Kabels 87 mit einer elektronischen Einrichtung 88 zur Datenverarbeitung verbunden ist.
Die letztgenannte Einrichtung weist eine Mehrzahl von Anschlüssen 89 zum Anschliessen der Uhr 86 und mehrerer gleichartiger weiterer Uhren auf, die anderen Schwimmbahnen zugeordnet sind. Ferner ist die Einrichtung 88 mit einem Steuereingang 90 für ein Startsignal versehen, das sämtliche angeschlossenen Uhren 86 in Gang setzt und auch akustisch hörbar
gemacht wird, um die Wettschwimmer zum Starten zu veranlassen.
Wenn ein Schwimmer mit einer Hand an der Zielanschlagplatte 53 anschlägt, entsteht, wie beschrieben, am Ausgang 69 der
Schaltungsanordnung 62 (Fig. 11) ein Steuersignal, das über
das Kabel 85 die zugeordnete Uhr 86 augenblicklich stoppt,
wobei über das Kabel 87 die gemessene Zeitdauer in einen Speicher der elektronischen Einrichtung 88 eingespeichert wird.
In bekannter Weise ist die Einrichtung 88 ferner derart ausgebildet, dass sie imstande ist, die eingespeicherten Zeitangaben der Grösse nach zu ordnen und eine Rangliste zu erstellen.

Um die Sicherheit der Zeitmessung zu erhöhen, können sämtliche
elektronischen Mittel für die Zeitmessung zweifach vorhanden
sein und die Zielanschlagplatte 53 gemäss Fig. 7 mit zwei voneinander unabhängigen Gruppen von piezoelektrischen Organen 11
bzw. 11' versehen sein. Zweckmässig ist jeweils eine vertikale Reihe mit vier piezoelektrischen Organen 11 zwischen zwei
vertikalen Reihen mit ebenfalls vier piezoelektrischen Organen
11' angeordnet, wobei sämtliche piezoelektrischen Organe 11
der Zielanschlagplatte parallel geschaltet und an den Signaleingang der zugehörigen elektrischen Schaltungsanordnung 62
(Fig. 11) angeschlossen sind und sämtliche piezoelektrischen
Organe 11' der Zielanschlagplatte ebenfalls parallel geschaltet und in analoger Weise an eine gleichartige zweite elektrische Schaltungsanordnung angeschlossen sind.

Eine andere Möglichkeit der doppelten Zeitmessung ist in Fig.8
schematisch veranschaulicht. Die dort dargestellte Zielanschlagplatte 53 ist wie bei dem Beispiel nach Fig. 6 mit einer
Mehrzahl von in Abständen voneinander angeordneten piezoelektrischen Organen 11 versehen, die alle parallel geschaltet
und mit dem Signaleingang der zugehörigen elektrischen Schaltungsanordnung 62 (Fig. 11) verbunden sind. Zusätzlich ist
an der der Wand 50 des Schwimmbeckens 51 zuzuwendenden Seite
der Zielanschlagplatte 53 ein Lichtleiterkabel 91 derart befestigt, dass es mäanderartig durch Zwischenräume zwischen den
piezoelektrischen Organen 11 verläuft. Es handelt sich bei dem Lichtleiterkabel 91 um ein druckempfindliches Glasfaserkabel, das z.B. eine Gradientenindex-Einzelfaser mit einem Kerndurchmesser von 50 μm und einem Mantelaussendurchmesser von 125 μm aufweist. Die beiden Enden 92 des Lichtleiterkabels 91 sind je mit einer mechanisch geschützten Glasfaser 93 bzw. 94 gespleisst. Die Glasfaser 93 dient zum Zuführen von konstantem Licht aus einer (nicht dargestellten) Laser-Lichtquelle, während die andere Glasfaser 94 dazu dient, das durch das druckempfindliche Lichtleiterkabel 91 gegebenenfalls modulierte Licht einem (nicht dargestellten) optoelektronischen Lichtdetektor zuzuleiten. Die optoelektronisch erzeugten Signale werden dem Signaleingang einer (ebenfalls nicht dargestellten) Schaltungsanordnung ähnlich derjenigen gemäss Fig. 11 zugeleitet.

In Fig. 5 ist schliesslich noch gezeigt, dass der Startbock 52 mit einer Startplatte 100 belegt ist, deren Oberseite Gleitschutzrillen 101 aufweist. Die Startplatte 100 besteht aus dem gleichen oder einem ähnlichen Hart-Kunststoff wie die Zielanschlagplatte 53. An ihrer Unterseite ist die Startplatte 100 mit einer Mehrzahl von piezoelektrischen Organen 11 versehen, die z.B. in vier Reihen mit je vier piezoelektrischen Organen angeordnet sind, wie Fig. 10 zeigt. Jedes dieser piezoelektrischen Organe 11 ist in einer Vertiefung der Platte 100 befestigt und gegen Berührung mit Wasser geschützt, und zwar gleich wie mit Bezug auf Fig. 9 beschrieben wurde. Sämtliche piezoelektrischen Organe 11 der Startplatte 100 sind elektrisch parallel geschaltet, wobei die hierfür erforderlichen elektrischen Verbindungsleitungen in Nuten 102 an der Unterseite der Startplatte eingebettet und gegen den Zutritt von Wasser abgedichtet sind. Ueber ein Kabel 103 sind die piezoelektrischen Organe 11 der Startplatte 100 mit dem am Startbock befestigten Gerät 61 verbunden und an den Signaleingang einer (nicht gezeigten) elektrischen Schaltungsanordnung angeschlossen, die grundsätzlich gleich wie die Schaltungsanordnung 62 gemäss Fig. 11 ausgebildet ist. Der Steuersignalausgang der genannten Schaltungsanordnung steht über das mehradrige Kabel 85 mit der elektronischen Uhr 86 und weiter
über das Kabel 87 mit der elektronischen Einrichtung 88 für
die Datenverarbeitung in Verbindung.

Wenn ein Schwimmer vom Startbock 52 abspringt, wird die Startplatte 100 schlagartig entlastet, wobei die piezoelektrischen
Organe 11 elektrische Spannungen erzeugen. Wenn die Frequenzen der erzeugten Spannungen innerhalb des Durchlassbereiches
des digitalen Bandpassfilters der angeschlossenen elektrischen
Schaltungsanordnung liegen, tritt am Ausgang dieser Schaltungsanordnung ein Steuersignal auf, welches den erfolgten
Absprung des Schwimmers an die elektronische Einrichtung 88
meldet. Letztere ist nun derart ausgebildet, dass sie imstande ist, festzustellen, ob das beim Absprung ausgelöste Steuersignal früher oder später als das am Signaleingang 90 eingegebene Startsignal eintrifft. Liegt das beim Absprung ausgelöste Steuersignal zeitlich vor dem Startsignal, handelt es
sich um einen Fehlstart und wird die Zeitmessung nicht in
Gang gesetzt.

Eine der Startplatte 100 analoge Startplatte mit mindestens
einem piezoelektrischen Organ kann auch bei anderen Wettkämpfen Verwendung finden, z.B. an einem Startpflock für Teilnehmer an Kurzstreckenrennen.

Es ist klar, dass noch zahlreiche andere Verwendungen der erfindungsgemässen piezoelektrischen Schalteinrichtung möglich
sind.

Bei einer nicht dargestellten Ausführungsvariante des digitalen Bandpassfilters 32 (Fig. 1 und 2) oder 68 (Fig. 11) kann
mindestens ein geschaltetes Kapazitäts-Filter ("Switching
Capacitance Filter") vorhanden sein.

P a t e n t a n s p r ü c h e

1. Elektrische Schalteinrichtung mit mindestens einem als mechanisch-elektrischer Wandler dienenden piezoelektrischen Organ (11) und einer elektrischen Schaltungsanordnung (12; 62), die einen mit dem piezoelektrischen Organ (11) verbundenen Signaleingang (14; 64) und einen Ausgang (16; 69) für ein elektrisches Steuersignal aufweist, dadurch gekennzeichnet, dass die elektrische Schaltungsanordnung (12; 62) einen Impedanzwandler (31; 65) und ein digitales Bandpassfilter (32; 68) aufweist mit einem Durchlassfrequenzbereich, dessen untere Grenzfrequenz im Bereich von 0,5 Hz bis 2 kHz liegt und dessen obere Grenzfrequenz höchstens 20 mal höher als die untere Grenzfrequenz ist.

2. Einrichtung nach Anspruch 1, dadurch gekennzeichnet, dass an den Ausgang (16) der elektrischen Schaltungsanordnung (12) eine durch das Steuersignal betätigbare weitere Schaltungsanordnung (13) mit Anschlussklemmen (18, 18') für den Speisestromkreis eines externen elektrischen Energieverbrauchers (19) angeschlossen ist, welche weitere Schaltungsanordnung (13) eine solche Ausbildung aufweist, dass mit ihrer Hilfe in Abhängigkeit vom Steuersignal der Speisestromkreis des Energieverbrauchers ein- und/oder ausschaltbar ist.

3. Einrichtung nach Anspruch 2, dadurch gekennzeichnet, dass das piezoelektrische Organ (11) einen plattenförmigen Piezokeramikkörper (20) aufweist, der auf seinen beiden Flachseiten mit Elektroden belegt ist, die mit dem Signaleingang (14) der elektrischen Schaltungsanordnung (12) verbunden sind, dass das piezoelektrische Organ (11) mit einer seiner Flachseiten an einer Innenfläche einer Wandpartie (22) eines Gehäuses (23) flach anliegend befestigt ist und dass die das piezoelektrische Organ (11) tragende Wandpartie (22) des Gehäuses (23) durch einen von aussen manuell ausgeübten
Betätigungsdruck 1 bis 10 μm elastisch deformierbar ist, um
das Auftreten eines Steuersignals herbeizuführen.

4. Einrichtung nach Anspruch 3, dadurch gekennzeichnet,
dass die elektrischen Schaltungsanordnungen (12, 13) ebenfalls in dem Gehäuse (23) untergebracht sind.

5. Einrichtung nach Anspruch 3, dadurch gekennzeichnet,
dass die untere Grenzfrequenz des digitalen Bandpassfilters
(32) 0,5 bis 2 Hz und die obere Grenzfrequenz 3 bis 10 Hz betragen

6. Einrichtung nach Anspruch 1 oder 2, dadurch gekennzeichnet, dass mindestens zwei piezoelektrische Organe (11)
vorhanden sind, die je einen plattenförmigen Piezokeramikkörper (20) aufweisen, der auf beiden Flachseiten mit Elektroden
belegt ist, die mit dem Signaleingang der elektrischen Schaltungsanordnung (62) in Verbindung stehen, dass die piezoelektrischen Organe (11) mit Abstand voneinander je mit einer
ihrer Flachseiten an einer gemeinsamen Platte (53; 100) flach
anliegend befestigt sind und dass die genannte Platte (53;
100) durch einen auf sie ausgeübten Betätigungsdruck elastisch
auf Biegung deformierbar ist, um das Auftreten von Steuersignalen herbeizuführen.

7. Einrichtung nach Anspruch 6, dadurch gekennzeichnet,
dass die Platte (53; 100) eine solche Ausbildung aufweist,
dass sie durch einen auf sie manuell ausgeübten Stoss in
elastische Biegeschwingungen versetzbar ist.

8. Einrichtung nach Anspruch 6, dadurch gekennzeichnet,
dass die Platte (53; 100) an einer ihrer Flachseiten mindestens zwei Vertiefungen (57) aufweist, in denen je eines der
piezoelektrischen Organe (11) angeordnet ist.

9. Einrichtung nach einem der Ansprüche 6 bis 8, dadurch gekennzeichnet, dass die Platte (53; 100) aus einem polymeren Hart-Kunststoff besteht, vorzugsweise aus Hart-Polyvinylchlorid oder Polyvinylchlorid-Hartschaum.

10. Einrichtung nach einem der Ansprüche 6 bis 9, dadurch gekennzeichnet, dass die Platte (53) für ihre Verwendung als Zielanschlagplatte in einem Schwimmbecken zum Zwecke einer elektronischen Zeitmessung ausgebildet ist und dass die untere Grenzfrequenz des digitalen Bandpassfilters (68) 0,5 bis 2 kHz und die obere Grenzfrequenz 5 bis 20 kHz betragen.

11. Einrichtung nach einem der Ansprüche 6 bis 8, dadurch gekennzeichnet, dass die Platte (100) für ihre Verwendung als Startplatte für Sportler zum Zwecke einer elektronischen Zeitmessung und/oder Fehlstart-Ueberwachung ausgebildet ist.

12. Einrichtung nach einem der Ansprüche 1 bis 11, dadurch gekennzeichnet, dass das piezoelektrische Organ (11) ausser als mechanisch-elektrischer Wandler zum Auslösen eines Steuervorganges auch als elektrisch-mechanischer Wandler zum Erzeugen von Schallwellen eines akustisch wahrnehmbaren Signals vorgesehen ist, und dass die elektrische Schaltungsanordnung (12) mindestens einen Tonfrequenzoszillator (42) sowie Mittel (30, 40, 41, 43) zum zeitweisen Anschalten desselben an das piezoelektrische Organ (11) aufweist.

13. Einrichtung nach Anspruch 12, dadurch gekennzeichnet, dass der Ausgang (16) der elektrischen Schaltungsanordnung (12) mit dem Eingang eines monostabilen Multivibrators (40) verbunden ist, welcher die zeitliche Dauer der Zuleitung des tonfrequenten Ausgangssignals des Oszillators (42) zum piezoelektrischen Organ (11) steuert.

14. Einrichtung nach Anspruch 12 oder 13, dadurch gekennzeichnet, dass das piezoelektrische Organ (11) mittels einer elektronischen Umschaltvorrichtung (30) entweder mit dem Eingang des Impedanzwandlers (31) oder mit dem Ausgang des Oszillators (42) verbindbar ist und dass ein Steuereingang (42) der elektronischen Umschaltvorrichtung (30) mit dem Ausgang (16) der elektrischen Schaltungsanordnung (12) in Verbindung steht.

15. Einrichtung nach einem der Ansprüche 1 bis 14, dadurch gekennzeichnet, dass das digitale Bandpassfilter (32; 68) zwei retriggerbare monostabile Multivibratoren (33, 34; 71, 72) aufweist, deren Eingänge zusammengeschaltet sind und deren Ausgänge je mit einem Eingang einer elektronischen Verknüpfungsschaltung (35; 73 bis 78) in Verbindung stehen, und dass die Eigenschaltzeiten der monostabilen Multivibratoren (33, 34; 71, 72) etwa gleich der Periodenlänge von Eingangssignalen mit der unteren bzw. oberen Grenzfrequenz des Durchlassbereiches des Bandpassfilters (32; 68) sind.

16. Einrichtung nach einem der Ansprüche 1 bis 14, dadurch gekennzeichnet, dass das digitale Bandpassfilter mindestens ein geschaltetes Kapazitäts-Filter aufweist.

17. Einrichtung nach einem der Ansprüche 1 bis 16, dadurch gekennzeichnet, dass das piezoelektrische Organ (11) einen Piezokeramikkörper (20) in Form einer Scheibe mit 10 bis 20 mm Durchmesser und 0,5 bis 3 mm Dicke aufweist, die an ihren beiden Flachseiten mit Elektroden belegt ist.

18. Elektronische Zeitmesseinrichtung für Wettschwimmen, mit einer an einer Wand eines Schwimmbeckens befestigbaren Zielanschlagplatte (53), die mit mindestens zwei piezoelektrischen Organen (11) in mechanischer Wirkungsverbindung steht, wobei die piezoelektrischen Organe (11) an eine elektrische Schaltungsanordnung (62) zum Erzeugen eines Steuersignals für eine elektronische Uhr (86) angeschlossen sind, dadurch gekennzeichnet, dass die elektrische Schaltungsanordung (62)

- 5 -

0164662

einen Impedanzwandler (65) und ein digitales Bandpassfilter (68) aufweist mit einem Durchlassbereich, dessen untere Grenzfrequenz 0,5 bis 2 kHz und dessen obere Grenzfrequenz 5 bis 20 kHz betragen.

19. Zeitmesseinrichtung nach Anspruch 18, dadurch gekennzeichnet, dass die Zielanschlagplatte (53) aus einem polymeren Hart-Kunststoff besteht, vorzugsweise aus Hart-Polyvinylchlorid oder Polyvinylchlorid-Hartschaum, dass die piezoelektrischen Organe (11) je einen plattenförmigen Piezokeramikkörper (20) aufweisen, der auf seinen beiden Flachseiten mit Elektroden belegt ist, die mit einem Signaleingang (64) der elektrischen Schaltungsanordnung (62) verbunden sind, und dass die piezoelektrischen Organe (11) mit Abstand voneinander je mit einer ihrer Flachseiten an der Zielanschlagplatte (53) flach anliegend befestigt und gegen aussen wasserdicht abgeschirmt sind.

20. Zeitmesseinrichtung nach Anspruch 19, dadurch gekennzeichnet, dass die Zielanschlagplatte (53) an einer ihrer Flachseiten mindestens zwei Vertiefungen (57) aufweist, in denen je eines der piezoelektrischen Organe (11) angeordnet ist und die wasserdicht verschlossen sind.

21. Zeitmesseinrichtung nach einem der Ansprüche 18 bis 20, dadurch gekennzeichnet, dass elektrische Leitungen zum Verbinden der piezoelektrischen Organe (11) miteinander und mit dem Signaleingang der Schaltungsanordnung (62) in Nuten (59) der Zielanschlagplatte (53) wasserdicht eingebettet sind.

22. Zeitmesseinrichtung nach einem der Ansprüche 18 bis 21, dadurch gekennzeichnet, dass mit der Zielanschlagplatte (53) mindestens ein unabhängiges weiteres piezoelektrisches Organ (11') in mechanischer Wirkungsverbindung steht, das an eine zugeordnete weitere elektrische Schaltungsanordnung mit

0164662

einem Impedanzwandler und einem digitalen Bandpassfilter für die Erzeugung eines Steuersignals für eine weitere Uhr angeschlossen ist.

23. Zeitmesseinrichtung nach Anspruch 22, dadurch gekennzeichnet, dass die voneinander elektrisch unabhängigen piezoelektrischen Organe (10, 10') in Gruppen angeordnet sind, die miteinander abwechselnd über eine der Flachseiten der Zielanschlagplatte (53) verteilt sind.

24. Zeitmesseinrichtung nach einem der Ansprüche 18 bis 21, dadurch gekennzeichnet, dass zusätzlich zu den piezoelektrischen Organen (11) mindestens eine Lichtleitfaser (91) mit der Zielanschlagplatte (53) in mechanischer Wirkungsverbindung steht, welche Lichtleitfaser (91) an einem ihrer Enden mit einer Lichtquelle und an ihrem anderen Ende mit einer optoelektronischen Lichtempfangs- und Detektionseinrichtung verbunden ist, die ihrerseits an mindestens einen Signaleingang einer elektrischen Schaltungsanordnung mit einem digitalen Bandpassfilter zum Erzeugen eines Steuersignals für eine zweite Uhr angeschlossen ist.

25. Zeitmesseinrichtung nach Anspruch 23, dadurch gekennzeichnet, dass die Lichtleitfaser (91) mäanderartig durch Zwischenräume zwischen den piezoelektrischen Organen (11) verläuft.

26. Zeitmesseinrichtung nach einem der Ansprüche 18 bis 23, dadurch gekennzeichnet, dass die piezoelektrischen Organe (11; 11') je einen Piezokeramikkörper (20) in Form einer Scheibe mit 10 bis 20 mm Durchmesser und 0,5 bis 3 mm Dicke aufweisen, die an ihren beiden Flachseiten mit Elektroden belegt ist.

27. Zeitmesseinrichtung nach einem der Ansprüche 18 bis 26, dadurch gekennzeichnet, dass das digitale Bandpassfilter (68) zwei retriggerbare monostabile Multivibratoren (71, 72) aufweist, deren Eingänge zusammengeschaltet sind und deren
Ausgänge je mit einem Eingang einer elektronischen Verknüpfungsschaltung (73 bis 78) in Verbindung stehen, und dass
die Eigenschaltzeiten der monostabilen Multivibratoren (71,
72) etwa gleich der Periodenlänge von Eingangssignalen mit
der unteren bzw. oberen Grenzfrequenz des Durchlassbereiches
des Bandpassfilters (68) sind.

28. Zeitmesseinrichtung nach einem der Ansprüche 18
bis 26, dadurch gekennzeichnet, dass das digitale Bandpassfilter mindestens ein geschaltetes Kapazitäts-Filter aufweist.

0164662

**FIG.1**

**FIG. 2**

**FIG.3**

**FIG.4**

0164662

FIG.5

FIG.6

FIG.7

53

11

11

11'

11'

11'

FIG.8

93

94

92

53

91

11

FIG.9

53 (100)    20    57

58    11

FIG.10

100

11

102

103

**FIG.11**

**FIG.12**

**Europäisches Patentamt**

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| A | US-A-3 899 698 (SIEMENS)<br>* Spalte 13, Zeilen 21-36; Figur 16 *<br><br>--- | 1 | H 03 K 17/96 |
| A | US-A-4 379 245 (DYNASCAN)<br>* Spalte 7, Zeilen 19-55; Figur 6 *<br><br>--- | 1 | |
| A | US-A-3 824 486 (VERNITRON)<br>* Figur 1 *<br><br>--- | 1 | |
| A | PATENTS ABSTRACTS OF JAPAN, Band 5, Nr. 117 (E-67)(789), 16. Mai 1981; & JP - A - 5 656 037 (MATSUSHITA) 16.05.1981<br><br>--- | 1 | |
| A | ELECTRICAL DESIGN NEWS, Band 25, Nr. 14, 5. August 1980, Seite 130, Denver, US; V.L. PATIL et al.: "Pulse-width sieve counts the good and bad"<br>* Insgesamt *<br><br>----- | 1 | RECHERCHIERTE SACHGEBIETE (Int. Cl.4)<br><br>H 03 K 17/00<br>G 01 R 29/00 |

Der vorliegende Recherchenbericht wurde für alle Patentansprüche erstellt.

| Recherchenort | Abschlußdatum der Recherche | Prüfer |
|---|---|---|
| DEN HAAG | 21-08-1985 | ZAEGEL B.C. |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82